# EUROPÄISCHE PATENTSCHRIFT

(11) **EP 2 470 685 B1**
(45) Veröffentlichungstag und Bekanntmachung des Hinweises auf die Patenterteilung: **12.12.2018**
(21) Anmeldenummer: 10737914.1
(22) Anmeldetag: 02.08.2010
(51) Int. Cl.: C23C 16/455, C23C 16/44

(54) **CVD-REAKTOR UND VERFAHREN ZUM ABSCHEIDEN EINER SCHICHT**
CVD REACTOR AND METHOD FOR DEPOSITING A COATING
RÉACTEUR CVD ET PROCÉDÉ POUR DÉPOSER UNE COUCHE

(30) Priorität: 24.08.2009 DE 102009043840
(43) Veröffentlichungstag der Anmeldung: 04.07.2012
(73) Patentinhaber: Aixtron SE, 52134 Herzogenrath (DE)
(72) Erfinder: STRAUCH, Gerhard Karl, 52072 Aachen (DE); DAUELSBERG, Martin, 52074 Aachen (DE)
(74) Vertreter: Grundmann, Dirk
(86) Internationale Anmeldenummer: PCT/EP2010/061174
(87) Internationale Veröffentlichungsnummer: WO 2011/023493

(56) Entgegenhaltungen:
- US-A- 5 624 498
- US-A1- 2009 178 615

## Beschreibung

Die Erfindung betrifft einen CVD-Reaktor gemäß Anspruch 1 mit einer Prozesskammer deren Boden von einem Suszeptor zur Aufnahme von mit einer Schicht zu beschichtenden Substraten gebildet ist und deren Decke von der eine Vielzahl von gleichmäßig über ihre gesamte Fläche verteilte Gaseintrittsöffnungen aufweisenden Unterseite eines Gaseinlassorganes gebildet ist, wobei die Gaseintrittsöffnungen in streifenförmige, parallel zueinander verlaufende erste und zweite Gaseintrittszonen aufgeteilt sind, wobei die Gaseintrittsöffnungen einer ersten Gaseintrittszone mit einer gemeinsamen ersten Prozessgaszuleitung zum Einleiten eines ersten Prozessgases in die Prozesskammer verbunden sind, wobei die Gaseintrittsöffnungen einer zweiten Gaseintrittszone mit einer gemeinsamen zweiten Prozessgaszuleitung, die von der ersten Prozessgaszuleitung verschieden ist, zum Einleiten eines zweiten Prozessgases in die Prozesskammer verbunden ist und wobei die ersten und zweiten Gaseintrittszonen abwechselnd nebeneinander liegen.

Die Erfindung betrifft darüber hinaus ein Verfahren gemäß Anspruch 7 zum Abscheiden einer Schicht auf einem Substrat in einer Prozesskammer, deren Boden von einem Suszeptor gebildet ist, auf welchem das Substrat aufliegt, und deren Decke von einer Vielzahl von gleichmäßig über ihre gesamte Fläche verteilte Gaseintrittsöffnungen aufweisenden Unterseite eines Gaseinlassorganes gebildet ist, wobei die Gaseintrittsöffnungen in streifenförmige, parallel zueinander verlaufende erste und zweite Gaseintrittszonen aufgeteilt sind, wobei die Gaseintrittsöffnungen einer ersten Gaseintrittszone mit einer gemeinsamen ersten Prozessgaszuleitung verbunden sind, durch welche Prozessgaszuleitung ein erstes Prozessgas in die Prozesskammer eingeleitet wird, wobei die Gaseintrittsöffnungen einer zweiten Gaseintrittszone mit einer gemeinsamen zweiten Prozessgasleitung, die von der ersten Prozessgasleitung verschieden ist, verbunden sind, durch welche Prozessgasleitung ein zweites Prozessgas in die Prozesskammer eingeleitet wird, und wobei die ersten und zweiten Gaseintrittszonen abwechselnd nebeneinander liegen.

Eine gattungsgemäße Vorrichtung beschreibt die US 5,595,606. Innerhalb eines Reaktorgehäuses befindet sich dort ein Suszeptor, der von unten beheizt wird. Auf der Horizontalfläche des Suszeptors liegen ein oder mehrere Substrate auf. Die Auflagefläche für das Substrat bildet den Boden einer Prozesskammer. Die Decke der Prozesskammer wird von der Unterseite eines Gaseinlassorganes ausgebildet. Diese Unterseite bildet eine Gaseintrittsfläche aus, die eine Vielzahl von düsenartigen Gaseintrittsöffnungen ausbildet. Die Gaseintrittsöffnungen sind mit Zuleitungen verbunden, durch die verschiedene Prozessgase zu den Gaseintrittsöffnungen geleitet werden können. Die Gaseintrittsöffnungen sind streifenförmig, parallel zueinander verlaufenden ersten und zweiten Gaseintrittszonen zugeordnet, wobei sich die ersten und zweiten Gaseintrittszonen nebeneinander abwechseln. Durch die erste Gaseintrittszone wird ausschließlich das erste Prozessgas und durch die zweite Gaseintrittszone ausschließlich das zweite Prozessgas jeweils mit einem Trägergas in die Prozesskammer geleitet. Die Breite der Gaseintrittszonen entspricht dem Abstand zweier benachbarter Gaseintrittsöffnungen. Die Höhe der Prozesskammer ist deutlich größer als der Abstand zweier Gaseintrittszonen.

Die WO2008/032910A1 beschreibt einen CVD-Reaktor bei dem das Gaseinlassorgan in der Lage ist, drei verschiedene Prozessgase in die Prozesskammer einzuleiten. Auf der Unterseite des Gaseinlassorganes befindet sich eine Vielzahl von Gaseintrittsöffnungen, die in einer Linie hintereinander liegen. Drei Streifen, die jeweils eine einreihige Anordnung von Gasaustrittsdüsen aufweisen liegen sich abwechselnd nebeneinander. Neben den einzelnen Reihen sind Spülgasaustrittsöffnungen angeordnet. Eine dieser Reihen geht durch den Mittelpunkt des kreisförmigen Gaseinlassorganes und ist von Reihen von Austrittsöffnungen für zwei voneinander verschiedene reaktive Gase benachbart, so dass eine asymmetrische Anordnung gegeben ist.

Die US 4,880,163 beschreibt einen CVD-Reaktor mit einem Gaseinlassorgan, welches streifenförmig nebeneinander angeordnete Gaseintrittszonen für voneinander verschiedene Prozessgase aufweist.

Die US 6,090,210 beschreibt einen CVD-Reaktor mit zu verschiedenen koaxial das Zentrum eines Gaseinlassorganes umgebenden Gaseintrittszonen für voneinander verschiedene Prozessgase.

Das US 5,500,256 beschreibt spiralförmig verlaufende Gaseintrittszonen, wobei auch hier die Zonenbreite dem einfachen Abstand zweier voneinander benachbarter Gaseintrittszonen entspricht.

Die DE 10 2005 055 468 A1 beschreibt ein Verfahren zum Abscheiden von Schichten in einem CVD-Reaktor. Auch hier treten die voneinander verschiedenen Prozessgase aus voneinander verschiedenen Gaseintrittszonen in die Prozesskammer ein. Gaseinlassorgane zum Einbringen voneinander verschiedener Prozessgase in eine Prozesskammer, wobei jedem Prozessgas ein individueller Satz von Gaseintrittsdüsen zugeordnet ist, werden des Weiteren beschrieben in US 2009/178615 A1, US 5 624 498 A, EP 1 118 691 A1, US 6,086,677, US 2004/0040502 A1, US 2004/0191413 A1, US 2006/0201428 A1 und US 2007/0101929 A1.

Die nicht vorveröffentlichte WO2010/065695 A2 beschreibt nebeneinander angeordnete Gaseinlassstreifen, die als Diffusoren ausgebildet sind, um voneinander verschiedene Prozessgase getrennt voneinander in eine Prozesskammer einzuleiten.

Eine gattungsgemäße Vorrichtung besitzt ein Reaktorgehäuse, das gegenüber der Umgebung gasdicht geschlossen ist und in seinem Inneren eine Prozesskammer aufweist, die die Form eines Kreiszylinders besitzt, deren kreisscheibenförmiger Boden von einem von unten beheizten Suszeptor und deren kreisscheibenförmige Decke von einem ebenfalls beheizbaren Gaseinlassorgan ausgebildet wird. Auf dem Substrathalter können ein oder mehrere Substrate liegen. Der Substrathalter kann eine Vielzahl von einzelnen, jeweils ein oder mehrere Substrate tragenden Lagerscheiben aufweisen, die auf einem Gaspolster lagernd drehangetrieben werden. Der von einer zentralen Säule getragene Suszeptor kann um die Symmetrieachse der Prozesskammer gedreht werden. Durch die erste Gaseintrittszone kann zusammen mit einem Trägergas, bei dem es sich um Wasserstoff, Stickstoff oder ein Edelgas handelt, eine gasförmige metallorganische Verbindung in die Prozesskammer eingeleitet werden. Es handelt sich hierbei bspw. um TMGa, TMIn oder um TMA1. Das zweite Prozessgas, welches durch die zweite Gaseintrittszone in die Prozesskammer eingeleitet wird, ist ein Hydrid, beispielsweise Arsin, Phosphin oder Ammoniak. Mit diesen Prozessgasen soll auf den Oberflächen der Substrate Halbleiterschichten abgeschieden werden, die aus Ga, In, Al, P, As und N bestehen können. Mit dieser Vorrichtung können aber nicht nur III-V-Halbleiterschichten, sondern auch durch geeignete Wahl anderer Ausgangsstoffe II-VI-Halbleiterschichten abgeschieden werden. Ferner ist es möglich, durch die Zugabe geeigneter, hochverdünnter, anderweitiger Ausgangsstoffe die abgeschiedenen Halbleiterschichten zu dotieren. Die in die Prozesskammer eingeleiteten Prozessgase zerlegen sich pyrolytisch. Optimal wäre es, wenn die Zerlegung erst auf der Substratoberfläche stattfindet. Da sich das sich oberhalb des Suszeptors innerhalb der Prozesskammer befindende Gas aber durch Wärmeleitung oder dergleichen aufheizt, sind Vorzerlegungen der Ausgangsstoffe nicht zu vermeiden. In nachteilhafter Weise reagieren die Vorzerlegungsprodukte der Ausgangsstoffe miteinander. Bei Temperaturen unterhalb von beispielsweise 500°C bilden die Vorzerlegungsprodukte Addukte. Die Adduktbildungstemperatur hängt von der Zusammensetzung der in die Prozesskammer eingeleiteten Prozessgase ab und liegt im Bereich zwischen 100°C und 500°C. Die durch die Teilzerlegung sich bildenden Addukte vermindern nicht nur die Kristallqualität der abgeschiedenen Schichten. Durch Keimbildung an den Addukten und daraus resultierenden Nukleationen können sich Konglomerate der Ausgangsstoffe bzw. deren Zerlegungsprodukte bilden, die durch Thermophorese an einer Abwärtsbewegung zur Substratoberfläche gehindert werden. Dieser nicht dem Kristallwachstum zur Verfügung stehende Anteil der sehr teuren Ausgangsstoffe wird vom Gasstrom zu einem Gasauslassorgan mitgeführt, wo es ungenutzt die Prozesskammer verlässt.

Der Erfindung liegt die Aufgabe zugrunde, Maßnahmen anzugeben, mit denen die Qualität der abgeschiedenen Schicht und die Effizienz des Beschichtungsprozesses verbessert werden kann.

Gelöst wird die Aufgabe durch die in den Ansprüchen angegebene Erfindung, wobei zunächst und im Wesentlichen die Vorrichtung dahingehend weitergebildet ist, dass die Breite der Gaseintrittszonen verbreitert worden ist. Es liegen jetzt mehrere Gaseintrittsöffnungen nicht nur hintereinander, sondern auch nebeneinander, so dass sich streifenförmige Gaseintrittszonen ausbilden, wobei jede Gaseintrittszone eine Breite aufweist, die im Wesentlichen dem vierfachen Abstand zweier benachbarter Gaseintrittsöffnungen entspricht. Die Gaseintrittszonen erstrecken sich im Wesentlichen über die gesamte Breite des kreisförmigen Gaseinlassorganes und besitzen quer zur Erstreckungsrichtung nebeneinander liegende Gasaustrittsöffnungen. Die nahe dem Zentrum sich erstreckenden Gaseintrittszonen sind die längsten. Im Bereich der Peripherie erstrecken sich die kürzesten Gaseintrittszonen. Die Gaseintrittszonen, durch die voneinander verschiedene Prozessgase in die Prozesskammer eingeleitet werden, liegen bevorzugt unmittelbar nebeneinander. In einer bevorzugten Ausgestaltung der Erfindung liegen deshalb zwischen zwei Gaseintrittszonen keine weiteren Gaseintrittsöffnungen, durch die ein Spülgas oder dergleichen in die Prozesskammer eingeleitet wird. Die Gaseintrittsöffnungen einer jeden Gaseintrittszone werden von Gasverteilkammern gespeist, die wiederum mit Zuleitungen verbunden sind. Die Höhe der Prozesskammer entspricht der Breite der Zone, also ebenfalls etwa dem vierfachen Abstand voneinander benachbarter Gaseintrittsöffnungen. Die Gaseintrittsöffnungen sind auf der Unterseite des Gaseinlassorganes gleichmäßig angeordnet. Sie können auf den Eckpunkten von Rechtecken, insbesondere Quadraten, oder auf den Eckpunkten von gleichseitigen Dreiecken liegen. Die Anordnung der streifenförmig nebeneinander liegenden, sich abwechselnden Gaseintrittszonen ist so gewählt, dass das Zentrum der einen kreisförmigen Umriss aufweisenden Gaseintrittsfläche in einer Zonengrenze liegt. Durch dieses Zentrum verläuft auch die Drehachse, um die der ebenfalls eine kreisförmige Umrisskontur aufweisende Suszeptor drehbar ist. Der Durchmesser der Gaseintrittsöffnungen beträgt etwa 0,6 mm ± 10%. Ihr Abstand, also die Kantenlänge des Quadrates, auf dessen Eckpunkten sich die Gaseintrittsöffnungen befinden, beträgt etwa 2,6 mm ± 10%, so dass sich eine optimale Prozesskammerhöhe von etwa 11 mm ± 10% ergibt. Der Durchmesser des Suszeptors bzw. der Gaseintrittsfläche und somit der Prozesskammer ist größer als 300 mm. Typischerweise beträgt deren Durchmesser etwa 32 cm. Das in dem CVD-Reaktor durchgeführte Verfahren zeichnet sich dadurch aus, dass durch die ersten Gaseintrittszonen jeweils ein erstes Prozessgas und durch die zweiten Gaseintrittszonen jeweils ein zweites Prozessgas in die Prozesskammer jeweils zusammen mit einem Trägergas eingeleitet werden, wobei das erste Prozessgas eine der zuvor genannten metallorganischen Verbindungen enthält und das zweite Prozessgas eines der zuvor genannten Hydride enthält. Bei dem Trägergas kann es sich um Wasserstoff, Stickstoff oder um ein Edelgas handeln. Um das Hydrid in einem effektiven Überschuss an der Wachstumsoberfläche anzubieten, wird der Abscheideprozess bei Totaldrücken von 500 mbar bis 1.000 mbar und bevorzugt bei etwa 600 mbar durchgeführt. Der Massenfluss durch die Gaseintrittsöffnungen in die Prozesskammer ist so gewählt, dass in der oberen Hälfte des Prozesskammervolumens die Strömung relaxiert und sich die Prozessgase vermischen, damit sie in der unteren Prozesskammerhälfte im Wesentlichen durch Diffusion zur Substratoberfläche transportiert werden. Durch die mit der kontinuierlichen Drehung des Suszeptors einhergehende Homogenisierung wird dadurch eine gleichmäßige Beschichtung erreicht. Es gibt keine lokalen Abweichungen von der mittleren Kristallzusammensetzung, die nicht tolerierbar ist. In der oberen Hälfte des Prozesskammervolumens und in den oberen Bereichen der unteren Hälfte des Prozesskammervolumens treten die voneinander verschiedenen Prozessgase im Wesentlichen nur im Bereich der Zonengrenze in Kontakt zueinander. Nur in diesem Bereich können sich die eingangs erwähnten, zu vermeidenden Addukte bilden. Die eingangs erwähnten schädlichen Verlustmechanismen über die Clusterbildung ist mit den erfindungsgemäßen Maßnahmen zwar nicht vollständig vermeidbar aber erheblich reduzierbar. Es kann auf zwischen den einzelnen Gaseintrittszonen angeordnete Spülzonen verzichtet werden. Das im jeweiligen Zentralbereich einer Zone, also durch die beiden inneren Gaseintrittsöffnungen der jeweiligen Gaseintrittszone in die Prozesskammer eingeleitete Prozessgas trifft erst an der Grenze zum unteren Bereich der Prozesskammer mit dem jeweils anderen Prozessgas zusammen. Bis dahin kann sich das jeweilige Prozessgas und insbesondere die metallorganische Komponente zwar in ein oder mehrere Zerlegungsprodukte zerlegt haben. Die verbleibende Reaktionszeit ist aber wegen des verminderten Wegs zum Substrat erheblich reduziert worden. Modellrechnungen haben ergeben, dass diese Reaktionszeit für die Addukt- und Clusterbildung von einer sehr hohen Bedeutung ist. Reduziert man durch geeignete Maßnahmen diese Reaktionszeit, so wird zwangsläufig auch die Clusterbildung und damit der schädlicher Verlustmechanismus vermindert. Die Oberflächentemperatur des Suszeptors kann also durchaus über 1.000°C und insbesondere 1.100°C betragen. Die Diffusionslänge der in die Prozesskammer eingeleiteten Precursor beträgt bei den Prozessbedingungen, also bei einem Totaldruck von mindestens 500 mbar und bei Gastemperaturen von mindestens 500°C, etwa die halbe Prozesskammerhöhe. Die Prozesskammerhöhe wird deshalb so gewählt, dass sie dem Doppelten der Diffusionslänge entspricht.

Ein Ausführungsbeispiel der Erfindung wird nachfolgend anhand beigefügter Zeichnungen erläutert. Es zeigen:
- Fig. 1: schematisch den Querschnitt durch eine innerhalb eines Reaktorgehäuses angeordneten Prozesskammer,
- Fig. 2: eine Unteransicht auf die Gaseintrittsfläche des Gaseinlassorganes 5,

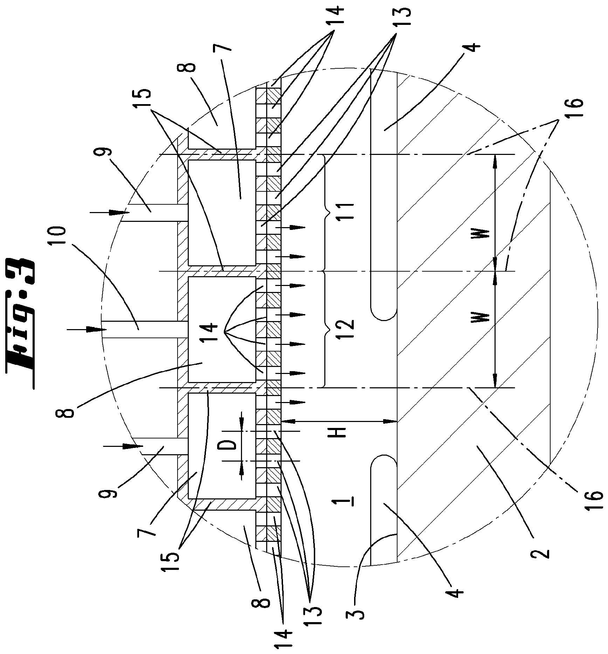

- Fig. 3: einen vergrößerten Abschnitt III - III in Fig. 1 des Querschnitts der Prozesskammer und
- Fig. 4: den schematischen Aufbau eines CVD-Reaktors mit Gasmischsystem.

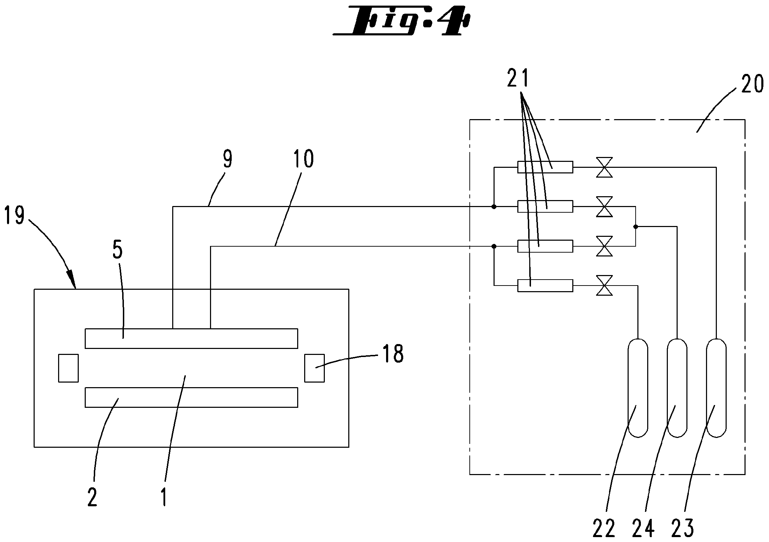

Die Fig. 4 zeigt den schematischen Aufbau eines erfindungsgemäßen CVD-Reaktors, in welchem das erfindungsgemäße Verfahren durchführbar ist. Das mit der Bezugsziffer 19 dargestellte Reaktorgehäuse 19 kapselt die sich zwischen einem Gaseinlassorgan 5 und einem Suszeptor 2 erstreckende Prozesskammer 1 gegenüber der Umwelt gasdicht ab. Die Prozessgase werden über zumindest zwei Zuleitungen 9, 10 in die Prozesskammer 1 geleitet. Das die Prozessgase tragende Trägergas wird mit Reaktionsprodukten durch einen Gasauslassring 18 aus der Prozesskammer 1 und nicht dargestellten Austrittsleitungen aus dem CVD-Reaktorgehäuse 19 gebracht.

Die erste Zuleitung 9 und die zweite Zuleitung 10 werden von einem Gasmischsystem 20 gespeist. Das Gasmischsystem 20 besitzt einen Vorratsbehälter für eine metallorganische Komponente, die ein erstes Prozessgas ausbildet. Es kann sich dabei um TMGa, TMIn oder TMA1 handeln. Bei dem zweiten Prozessgas, welches in dem Vorratsbehälter 22 bevorratet wird, handelt es sich um ein Hydrid, beispielsweise Arsin, Phosphin oder um Ammoniak. Der die metallorganische Komponente beinhaltenden Vorratsbehälter 23 kann die Form einer Waschflasche aufweisen, die von einem Trägergas durchströmt wird. Bei dem Trägergas, welches in dem Vorratsbehälter 24 insbesondere zentral bevorratet wird, befindet sich ein Trägergas in Form von Wasserstoff, Stickstoff oder einem Edelgas. Mittels Massenflusscontrollern 21 und vor- bzw. nachgeschalteten Ventilen werden die beiden Prozessgase zusammen mit dem Trägergas in die jeweilige Zuleitung 9, 10 dosiert eingespeist.

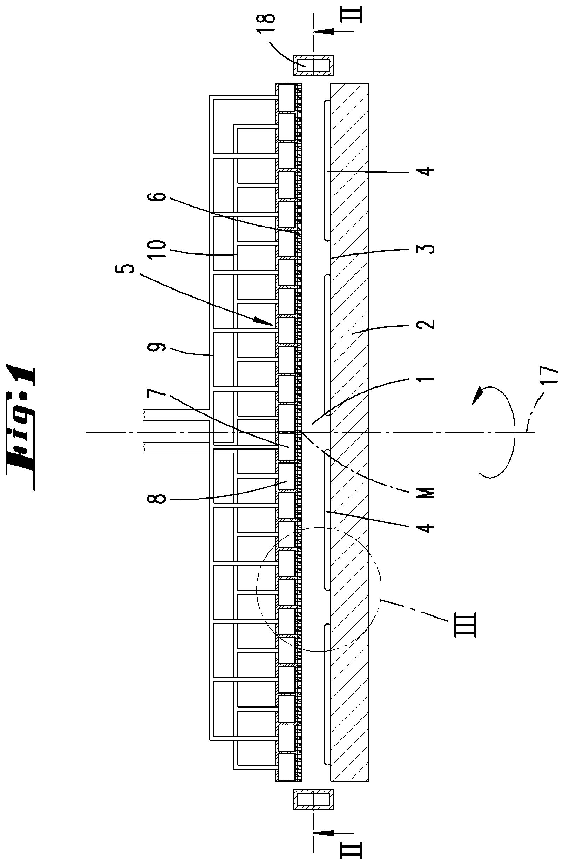

Wie der Fig. 1 zu entnehmen ist, verzweigen sich die jeweiligen ersten Zuleitungen 9 und zweiten Zuleitungen 10 vielfach, so dass mit einem ersten Prozessgas durch eine erste Zuleitung 9 eine Vielzahl erster Verteilkammern 7 des Gaseinlassorganes 5 und mit einem zweiten Prozessgas durch eine zweite Zuleitung 10 eine Vielzahl zweiter Verteilkammern 8 des Gaseinlassorganes 5 versorgt werden.

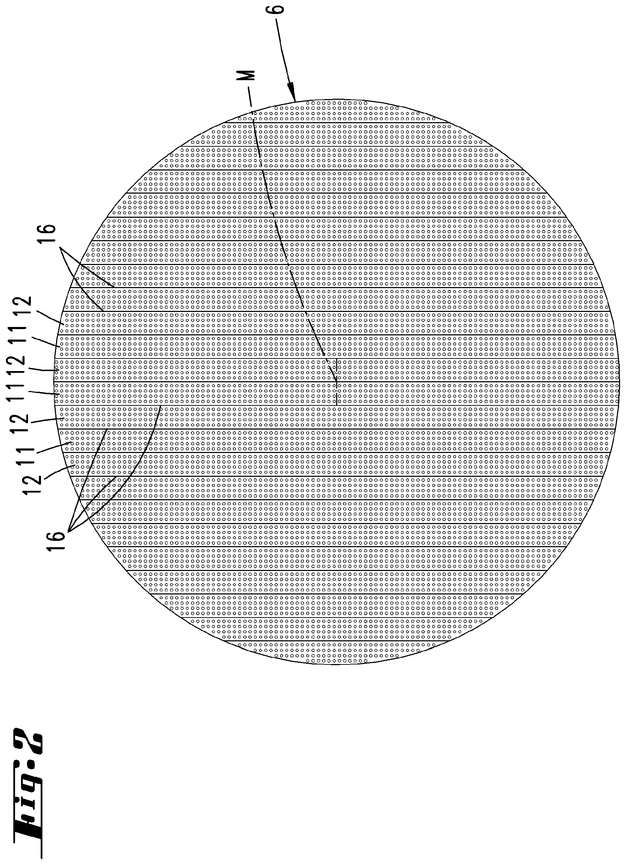

Das Gaseinlassorgan besitzt einen kreisförmigen Grundriss und eine Unterseite 6, die eine Vielzahl von gleichmäßig über ihre Oberfläche verteilte Gaseintrittsöffnungen 13, 14 aufweist. Wie der Fig. 2 zu entnehmen ist, liegen die einzelnen Gaseintrittsöffnungen 13, 14 auf den Eckpunkten von gedachten Quadraten.

Die Gaseintrittsöffnungen 13, 14 sind voneinander verschiedenen Gaseintrittszonen 11, 12 zugeordnet. Es sind zwei verschiede Arten von Gaseintrittszonen 11, 12 vorgesehen, denen jeweils eine erste Verteilkammer 7 und eine zweite Verteilkammer 8 individuell zugeordnet sind. Durch die Gaseintrittszonen 11 der ersten Art treten ausschließlich das erste in einem Trägergas gelöste Prozessgas in die Prozesskammer 1 ein. Durch die Gaseintrittszonen der zweiten Art treten ausschließlich das zweite Prozessgas zusammen mit einem Trägergas in die Prozesskammer 1 ein. Die Gaseintrittszonen 11, 12 der ersten und zweiten Art sind streifenartig ausgebildet. Die Gaseintrittszonen 11, 12 wechseln sich untereinander ab, so dass bis auf die beiden zuäußerst liegenden Gaseintrittszonen jede Gaseintrittszone 11 der ersten Art von zwei Gaseintrittszonen 12 der zweiten Art benachbart ist und jede Gaseintrittszone 12 der zweiten Art von zwei Gaseintrittszonen 11 der ersten Art benachbart ist. Die Zonengrenzen 16 zwischen zwei voneinander verschiedenen Gaseintrittszonen 11, 12 verlaufen unterhalb von Trennwänden 15, die die beiden voneinander verschiedenen, ebenfalls streifenförmig nebeneinander verlaufenden Verteilkammern 7, 8 voneinander trennen.

Die Gaseintrittszonen 11, 12 erstrecken sich parallel zueinander verlaufend von einem Rand der Gaseintrittsfläche 6 des Gaseinlassorganes 5 unterbrechungsfrei bis zum gegenüberliegenden Rand der Gaseintrittsfläche 6 des Gaseinlassorganes 5. Dabei sind die Trennwände 15 so angeordnet, dass eine Trennwand 15 und die diese definierende Zonengrenze 16 durch den Mittelpunkt M der Gaseintrittsfläche 6 geht. Der Mittelpunkt M wird somit von zwei voneinander verschiedenen Gaseintrittszonen 11, 12 flankiert, wobei diese Gaseintrittszonen 11, 12 die längsten sind. Die beiden kürzesten Gaseintrittszonen 11, 12 liegen am äußersten Rand der Gaseintrittsfläche 6.

Der Durchmesser der untereinander gleich gestalteten Gaseintrittsöffnungen 13 der ersten Art und Gaseintrittsöffnungen 14 der zweiten Art beträgt etwa 0,6 mm. Die Gaseintrittsöffnungen 13, 14 sind um etwa 2,6 mm voneinander beabstandet. Die Länge der Gaseintrittszonen 11, 12 ist unterschiedlich. Ihre Breite ist jedoch gleich. Die Breite der Gaseintrittszonen 11, 12 ist so gewählt, dass vier Gaseintrittsöffnungen 13, 14 einer jeden Gaseintrittszone 11, 12 nebeneinander liegen. Die Weite W einer Gaseintrittszone 11, 12 entspricht somit dem Vierfachen des Abstandes D zweier Gaseintrittsöffnungen 13, 14. Die Breite einer jeden Gaseintrittszone 11, 12 wird im Wesentlichen definiert durch die Anzahl der Gaseintrittsöffnungen 13, 14, die quer zur Erstreckungsrichtung der Gaseintrittszonen 11, 12 nebeneinander liegen.

Es wird als vorteilhaft angesehen, wenn Gaseintrittszonen 11, 12, durch die voneinander verschiedene Prozessgase in die Prozesskammer einströmen, unmittelbar aneinander angrenzen. Es ist nicht erforderlich, dass zwischen den Gaseintrittszonen der ersten Art und Gaseintrittszonen der zweiten Art Spülgasöffnungen vorgesehen sind, durch die ein Inertgas in die Prozesskammer eingeleitet wird.

Der unterhalb, parallel zum Gaseinlassorgan 5 angeordnete Suszeptor 2 besitzt eine Oberfläche 3, auf der eine Vielzahl von Substraten 4 angeordnet ist. Die Substrate 4 können dort in dichtester Packung auf dem aus Graphit bestehenden kreisförmigen Suszeptor 2 aufliegen. Mit nicht dargestellten Antriebsmitteln kann der Suszeptor 2 um die Drehachse 17, die durch den Mittelpunkt M des Gaseinlassorganes 5 geht, drehangetrieben werden. Die einzelnen Substrate 4 können auch auf drehangetriebenen Lagerscheiben liegen.

Die Höhe H der Prozesskammer 1, also der Abstand zwischen Boden 3 und Decke 6 ist so gewählt, dass die aus den beiden inneren Öffnungen 13, 14 der jeweiligen Gaseintrittszonen 11, 12 austretenden Prozessgase erst in der unteren Hälfte und bevorzugt erst im unteren Bereich der unteren Hälfte des Prozesskammervolumens 1 mit dem jeweils anderen Prozessgas in Berührung treten. Innerhalb der oberen Hälfte der Prozesskammer 1 mischen sich somit lediglich die aus den jeweiligen der Zonengrenze 16 benachbarten Gaseintrittsöffnungen 13, 14 austretenden Prozessgase miteinander. Eine Adduktbildung ist somit dort auf den unmittelbaren Bereich um die Zonengrenze 16 beschränkt. Optimal ist es, wenn die Höhe H der Prozesskammer 1 der doppelten Diffusionslänge des im Trägergas gelösten Prozessgases entspricht. Der Totaldruck innerhalb der Prozesskammer liegt im Bereich zwischen 500 mbar und 1.000 mbar und bevorzugt bei etwa 600 mbar. Die Substrattemperatur liegt bei etwa 1.100°C. Die Oberflächentemperatur der Prozesskammerdecke 6 liegt bei etwas mehr als 500°C bzw. 600°C. Diese Temperatur hängt von der Zusammensetzung der Prozessgase ab, von welcher Zusammensetzung die Adduktbildungsgrenztemperatur abhängt, die im Bereich von 500°C bis 600°C liegt. Die Temperatur der Prozesskammerdecke 6 wird aber unterhalb der Wachstumstemperaturgrenze für das kinetische Wachstum gehalten, die abhängig von den Prozessgasen im Bereich zwischen 850°C und 900°C liegt.

Um diesen Anforderungen gerecht zu werden, entspricht die Höhe H der Prozesskammer 1 etwa dem Wert, den die Breite W der Gaseintrittszonen 11, 12 besitzt. Alle Gaseintrittszonen 11, 12 besitzen die gleiche Weite W von etwa 10,4 mm. Im Ausführungsbeispiel besitzt die Prozesskammer eine Höhe von 11 mm. Der Durchmesser der Prozesskammer, die von einem Gasauslassring 18 umgeben ist, beträgt etwa 32 cm. Hierdurch ergibt sich ein Reaktorvolumen von etwa 900 cm³. Das Volumen, in welchem sich die Addukte in der oberen Hälfte der Prozesskammer bilden können, ist reduziert auf etwa 40 cm³. Im Zentralbereich der Gaseintrittszonen 11, 12 können sich zwar ebenfalls Addukte bilden, da dort im unteren Bereich des Prozesskammervolumens eine Durchmischung gewünscht ist. Die dort sich bildenden Addukte haben aber nur eine geringe Wegstrecke bis zur Oberfläche des Substrates 4 und damit nur eine sehr geringe Reaktionszeit, so dass eine Clusterbildung wirksam vermindert ist.

## Patentansprüche

1. CVD-Reaktor mit einer Prozesskammer (1), deren Boden (3) von einem Suszeptor (2) zur Aufnahme von mit einer Schicht zu beschichtenden Substraten (4) gebildet ist und deren Decke (6) von der eine Vielzahl von gleichmäßig über ihre gesamte Fläche verteilte Gaseintrittsöffnungen (13, 14) aufweisenden Unterseite eines Gaseinlassorganes (5) gebildet ist, wobei die Gaseintrittsöffnungen (13,14) in streifenförmige, in einer Erstreckungsrichtung parallel zueinander verlaufende erste und zweite Gaseintrittszonen (11,12) aufgeteilt sind, wobei die Gaseintrittsöffnungen (13) einer ersten Gaseintrittszone (11) mit einer gemeinsamen ersten Prozessgaszuleitung (9) zum Einleiten eines ersten Prozessgases in die Prozesskammer (1) verbunden sind, wobei die Gaseintrittsöffnungen (14) einer zweiten Gaseintrittszone (12) mit einer gemeinsamen zweiten Prozessgaszuleitung (10), die von der ersten Prozessgaszuleitung (9) verschieden ist, zum Einleiten eines zweiten Prozessgases in die Prozesskammer (1) verbunden ist und wobei die ersten und zweiten Gaseintrittszonen (11,12) abwechselnd nebeneinander liegen, wobei jede erste und zweite Gaseintrittszone (11,12) eine Vielzahl quer zur Erstreckungsrichtung nebeneinander liegende Gaseintrittsöffnungen (13,14) aufweisen, wobei der Abstand (D) der Gaseintrittsöffnungen (13,14) voneinander, die Höhe (H) der Prozesskammer (1) und die Breite (W) einer jeden Gaseintrittszone (11,12) so gewählt ist, dass bei einem Totaldruck in einem Bereich zwischen 500mbar und 1.000mbar durch Wahl der Massenflussrate eines zusammen mit den Prozessgasen durch die jeweiligen Gaseintrittszonen (11,12) in die Prozesskammer (1) eingeleiteten Trägergases eine vollständige Durchmischung der voneinander verschiedenen ersten und zweiten Prozessgase nur in der unteren Hälfte der Prozesskammer (1) stattfindet, wobei der Abstand (D) etwa einem Viertel der Höhe (H) beträgt und die Weite (W) etwa der Höhe (H) entspricht.

2. CVD-Reaktor nach Anspruch 1, **dadurch gekennzeichnet, dass** die Decke (6) und der Boden (3) etwa einen kreisförmigen Umriss aufweisen und der Suszeptor (2) um eine Drehachse (17) drehbar ist.

3. CVD-Reaktor nach einem der vorhergehenden Ansprüche, **dadurch gekennzeichnet, dass** eine Zonengrenze (16) einer ersten Gaseintrittszone (11) und einer zweiten Gaseintrittszone (12) durch das Zentrum der kreisscheibenförmigen Gaseinlassfläche (6) des Gaseinlassorganes (5) verläuft, durch welches Zentrum (M) die Drehachse (17) des Suszeptors (2) verläuft.

4. CVD-Reaktor nach einem der vorhergehenden Ansprüche, **dadurch gekennzeichnet, dass** der Abstand der reihenförmig auf einer Linie nebeneinander liegenden Gaseintrittsöffnungen (13,14) etwa 2,6 mm beträgt.

5. CVD-Reaktor nach einem der vorhergehenden Ansprüche, **dadurch gekennzeichnet, dass** die Prozesskammerhöhe (H) etwa 11 mm beträgt.

6. CVD-Reaktor nach einem der vorhergehenden Ansprüche, **dadurch gekennzeichnet, dass** der Durchmesser der Prozesskammer größer als 300 mm ist.

7. Verfahren zum Abscheiden einer Schicht auf einem Substrat in einer Prozesskammer (1), deren Boden (3) von einem Suszeptor (2) gebildet ist, auf welchem das Substrat (4) aufliegt, und deren Decke (6) von einer Vielzahl von gleichmäßig über ihre gesamte Fläche verteilte Gaseintrittsöffnungen (13,14) aufweisenden Unterseite eines Gaseinlassorganes (5) gebildet ist, wobei die Gaseintrittsöffnungen (13,14) in streifenförmige, in einer Erstreckungsrichtung parallel zueinander verlaufende erste und zweite Gaseintrittszonen (11,12) aufgeteilt sind, wobei die Gaseintrittsöffnungen (13) einer ersten Gaseintrittszone (11) mit einer gemeinsamen ersten Prozessgaszuleitung (9) verbunden sind, durch welche zweite Prozessgaszuleitung (9) ein erstes Prozessgas in die Prozesskammer (1) eingeleitet wird, wobei die Gaseintrittsöffnungen (14) einer zweiten Gaseintrittszone (12) mit einer gemeinsamen zweiten Prozessgasleitung (10), die von der ersten Prozessgasleitung verschieden ist, verbunden sind, durch welche Prozessgasleitung (10) ein zweites Prozessgas in die Prozesskammer (1) eingeleitet wird, und wobei die ersten und zweiten Gaseintrittszonen (11, 12) abwechselnd nebeneinander liegen, wobei jede erste und zweite Gaseintrittszone (11,12) eine Vielzahl quer zur Erstreckungsrichtung nebeneinanderliegende Gasaustrittsöffnungen (13,14) aufweisen, **dadurch gekennzeichnet, dass** bei einem Abstand (D) der Gaseintrittsöffnungen (13,14) voneinander, einer Höhe (H) der Prozesskammer (1), einer Breite (W) einer jeden Gaseintrittszone (11,12) und einem Totaldruck in einem Bereich zwischen 500 mbar und 1.000 mbar die Massenflussrate eines zusammen mit den Prozessgasen durch die jeweiligen Gaseintrittszonen (11,12) in die Prozesskammer (1) eingeleiteten Trägergases derart gewählt ist, dass eine vollständige Durchmischung der voneinander verschiedenen ersten und zweiten Prozessgase nur in der unteren Hälfte der Prozesskammer (1) stattfindet, wozu insbesondere der Abstand (D) etwa einem Viertel der Höhe (H) der Prozesskammer (1) beträgt und die Breite (W) einer jeden Gaseintrittszone (11,12) etwa der Höhe (H) entspricht.

8. Verfahren nach Anspruch 7, **dadurch gekennzeichnet, dass** das erste Prozessgas eine metallorganische Verbindung, insbesondere TMIn, TMGa oder TMA1 ist.

9. Verfahren nach einem der Ansprüche 7 oder 8, **dadurch gekennzeichnet, dass** das zweite Prozessgas ein Hydrid, insbesondere Arsin, Phosphin oder Ammoniak ist.

10. Verfahren nach einem der Ansprüche 7 bis 9, **dadurch gekennzeichnet, dass** die die Gaseintrittsöffnungen (13,14) aufweisende Gaseintrittsdecke (6) des Gaseinlassorganes (5) eine Temperatur aufweist, die oberhalb einer Adduktbildungstemperatur der ersten und zweiten Prozessgase liegt.

## Claims

1. CVD reactor having a process chamber (1), the floor (3) of which is formed by a susceptor (2) for receiving substrates (4) to be coated with a layer and the ceiling (6) of which is formed by the underside of a gas inlet element (5) that has a multiplicity of gas inlet openings (13, 14) distributed uniformly over its entire surface, the gas inlet openings (13, 14) being divided into strip-like first and second gas inlet zones (11, 12) that run parallel to one another in a direction of extent, the gas inlet openings (13) of a first gas inlet zone (11) being connected to a common first process-gas feed line (9) for introducing a first process gas into the process chamber (1), the gas inlet openings (14) of a second gas inlet zone (12) being connected to a common second process-gas feed line (10), which is different from the first process-gas feed line (9), for introducing a second process gas into the process chamber (1), and the first and second gas inlet zones (11, 12) lying alternatingly alongside one another, each first and second gas inlet zone (11, 12) having a multiplicity of gas inlet openings (13, 14) that lie side by side transverse to the direction of extent, the spacing (D) of two directly neighboring gas inlet openings (13, 14) being approximately one quarter of the height (H) of the process chamber (1) and the width (W) of an individual gas inlet zone (11, 12) corresponding approximately to the height (H), wherein the spacing (D) of the gas inlet openings (13, 14) from one another, the height (H) of the process chamber (1) and the width (W) of an individual gas inlet zone (11, 12) is selected such that at a total pressure in a range between 500 mbar and 1,000 mbar by selecting the mass flow rate of a carrier gas introduced into the process chamber (1) through the respective gas inlet zones (11, 12) together with the process gases is selected so that a thorough mixing of the first and second process gases being different from each other takes place only in the lower half of the process chamber (1), wherein the distance (D) is about a quarter of the height (H) and the width (W) corresponds approximately to the height (H).

2. CVD reactor according to Claim 1, **characterized in that** the ceiling (6) and the floor (3) have substantially a circular shape and the susceptor (2) is rotatable about an axis (17) of rotation.

3. CVD reactor according to one of the preceding claims, **characterized in that** a zone boundary (16) of a first gas inlet zone (11) and of a second gas inlet zone (12) runs through the center of the disk-shaped gas inlet surface (6) of the gas inlet element (5), through which center (M) there runs the axis (17) of rotation of the susceptor.

4. CVD reactor according to one of the preceding claims, **characterized in that** the spacing of the outlet openings (13, 14) that lie side by side on a line in the manner of a row is approximately 2.6 mm.

5. CVD reactor according to one of the preceding claims, **characterized in that** the height (H) of the process chamber is approximately 11 mm.

6. CVD reactor according to one of the preceding claims, **characterized in that** the diameter of the process chamber is greater than 300 mm.

7. Method for depositing a layer on a substrate in a process chamber (1), the floor (3) of the chamber being formed by a susceptor (2) on which the substrate (4) lies, and the ceiling (6) of the chamber being formed by the underside of a gas inlet element (5) that has a multiplicity of gas inlet openings (13, 14) distributed uniformly over its entire surface, the gas inlet openings (13, 14) being divided into strip-like first and second gas inlet zones (11, 12) that run parallel to one another in a direction of extent, the gas inlet openings (13) of a first gas inlet zone (11) being connected to a common first process-gas feed line (9), through which process-gas feed line (9) a first process gas is introduced into the process chamber (1), the gas inlet openings (14) of a second gas inlet zone (12) being connected to a common second process-gas feed line (10), which is different from the first process-gas feed line (9), through which process-gas feed line (10) a second process gas is introduced into the process chamber (1), and the first and second gas inlet zones (11, 12) lying alternatingly alongside one another, wherein each first and second gas inlet zone (11, 12) shows a multiplicity of gas inlet openings (13, 14) that are assigned side by side transverse the direction of extent, **characterized in that** for a spacing (D) of the gas inlet openings (13, 14) from one another, a height (H) of the process chamber (1), a width (W) of an individual gas inlet zone (11, 12) and a total pressure in a range between 500 mbar and 1,000 mbar, the mass flow rate of a carrier gas introduced into the process chamber (1) through the respective gas inlet zones (11, 12) together with the process gases is selected so that a thorough mixing of the first and second process gases that are different from one another takes place only in the lower half of the process chamber (1), for which in particular the spacing (D) is approximately one quarter of the height (H) of the process chamber and the width (W) of an individual gas inlet zone (11, 12) corresponds approximately to the height (H).

8. Method according to Claim 7, **characterized in that** the first process gas is an organometallic compound, in particular TMIn, TMGa or TMAl.

9. Method according to one of Claim 7 or 8, **characterized in that** the second process gas is a hydride, in particular arsine, phosphine or ammonia.

10. Method according to one of Claims 7 to 9, **characterized in that** the gas inlet ceiling (6) of the gas inlet element (5) that has the gas inlet openings (13, 14) has a temperature that lies above an adduct formation temperature of the first and second process gases.

## Revendications

1. Réacteur CVD comprenant une chambre de traitement (1) dont le fond (3) est formé par un suscepteur (2) destiné à recevoir des substrats (4) à recouvrir d'une couche et dont le plafond (6) est formé par la face inférieure d'un élément d'admission de gaz (5) qui est pourvue d'une pluralité d'orifices d'entrée de gaz (13, 14) réparties uniformément sur toute la surface de celle-ci, les orifices d'entrée de gaz (13, 14) étant divisées en des première et deuxième zones d'entrée de gaz (11, 12) en forme de bande qui s'étendent parallèlement les unes aux autres dans une direction d'extension, les orifices d'entrée de gaz (13) d'une première zone d'entrée de gaz (11) étant reliés à un premier conduit d'alimentation en gaz de traitement commun (9) destiné à introduire un premier gaz de traitement dans la chambre de traitement (1), les orifices d'entrée de gaz (14) d'une deuxième zone d'entrée de gaz (12) étant reliées à un deuxième conduit d'alimentation en gaz de traitement commun (10), différent du premier conduit d'alimentation en gaz de traitement (9), qui est destiné à introduire un deuxième gaz de traitement dans la chambre de traitement (1) et les première et deuxième zones d'entrée de gaz (11, 12) étant situées alternativement les unes à côté des autres, chaque première et deuxième zone d'entrée de gaz (11, 12) comportant une pluralité d'orifices d'entrée de gaz (13, 14) situées les uns à côté des autres transversalement à la direction d'extension, la distance (D) entre les orifices d'entrée de gaz (13, 14), la hauteur (TT) de la chambre de traitement (1) et la largeur (W) de chaque zone d'entrée de gaz (11, 12) étant choisies de manière à ce que, dans le cas d'une pression totale comprise entre 500 mbar et 1000 mbar, une sélection du débit massique d'un gaz porteur introduit conjointement avec les gaz de traitement dans la chambre de traitement (1) à travers les zones d'entrée de gaz respectives (11, 12) permet d'effectuer un mélange complet des premier et deuxième gaz de traitement, différents l'un de l'autre, uniquement dans la moitié inférieure de la chambre de traitement (1), la distance (D) correspondant à environ un quart de la hauteur (H) et la largeur (W) correspondant environ à la hauteur (H).

2. Réacteur CVD selon la revendication 1, **caractérisé en ce que** le plafond (6) et le fond (3) ont approximativement un contour circulaire et le suscepteur (2) peut tourner sur un axe de rotation (17).

3. Réacteur CVD selon l'une des revendications précédentes, **caractérisé en ce qu'**une frontière de zone (16) d'une première zone d'entrée de gaz (11) et d'une deuxième zone d'entrée de gaz (12) passe par le centre de la surface d'entrée de gaz (6), en forme de disque circulaire, de l'élément d'entrée de gaz (5), l'axe de rotation (17) du suscepteur (2) passant par le centre (M).

4. Réacteur CVD selon l'une des revendications précédentes, **caractérisé en ce que** la distance entre les orifices d'entrée de gaz (13, 14), situés les uns à côté des autres sur une ligne en forme de rangée, est d'environ 2,6 mm.

5. Réacteur CVD selon l'une des revendications précédentes, **caractérisé en ce que** la hauteur (H) de la chambre de traitement est d'environ 11 mm.

6. Réacteur CVD selon l'une des revendications précédentes, **caractérisé en ce que** le diamètre de la chambre de traitement est supérieur à 300 mm.

7. Procédé de dépôt d'une couche sur un substrat dans une chambre de traitement (1) dont le fond (3) est formé par un suscepteur (2) sur lequel le substrat (4) est en appui et dont le plafond (6) est formé par la face inférieure d'un élément d'admission de gaz (5) qui est pourvue d'une pluralité d'orifices d'entrée de gaz (13, 14) réparties uniformément sur toute la surface de celle-ci, les orifices d'entrée de gaz (13, 14) étant divisées en des première et deuxième zones d'entrée de gaz (11, 12) en forme de bande qui s'étendent parallèlement les unes aux autres dans une direction d'extension, les orifices d'entrée de gaz (13) d'une première zone d'entrée de gaz (11) étant reliées à un premier conduit d'alimentation en gaz de traitement commun (9), un premier gaz de traitement étant introduit dans la chambre de traitement (1) par ledit premier conduit d'alimentation en gaz de traitement (9), les orifices d'entrée de gaz (14) d'une deuxième zone d'entrée de gaz (12) étant reliés à un deuxième conduit d'alimentation en gaz de traitement commun (10), différent du premier conduit d'alimentation en gaz de traitement (9), un deuxième gaz de traitement étant introduit dans la chambre de traitement (1) par ledit conduit de gaz de traitement (10) et les première et deuxième zones d'entrée de gaz (11, 12) étant situées alternativement les unes à côté des autres, chaque première et deuxième zone d'entrée de gaz (11, 12) comportant une pluralité d'orifices d'entrée de gaz (13, 14) situées les uns à côté des autres transversalement à la direction d'extension, **caractérisée en ce que**, pour un distance (D) entre les orifices d'entrée de gaz (13, 14), une hauteur (TT) de la chambre de traitement (1) et une largeur (W) de chaque zone d'entrée de gaz (11, 12) et une pression totale comprise entre 500 mbar et 1000 mbar, le débit massique d'un gaz porteur introduit conjointement avec les gaz de traitement dans la chambre de traitement (1) à travers les zones d'entrée de gaz respectives (11, 12) est choisi de telle sorte que un mélange complet des premier et deuxième gaz de traitement, différents l'un de l'autre, est effectué uniquement dans la moitié inférieure de la chambre de traitement (1), la distance (D) correspondant à environ un quart de la hauteur (H) de la chambre de traitement et la largeur (W) de chaque zone d'entrée de gaz correspondant environ à la hauteur (H).

8. Procédé selon la revendication 7, **caractérisé en ce que** le premier gaz de traitement est un composé organométallique, notamment TMIn, TMGa ou TMAl.

9. Procédé selon l'une des revendications 7 ou 8, **caractérisé en ce que** le deuxième gaz de traitement est un hydrure, notamment du tri-hydrure d'arsenic, de l'hydrure de phosphore ou de l'ammoniac.

10. Procédé selon l'une des revendications 7 à 9, **caractérisé en ce que** le plafond entrée de gaz (6), comportant des orifices d'entrée de gaz (13, 14), de l'élément d'admission de gaz a une température qui est supérieure à la température de formation d'adduit des premier et deuxième gaz de traitement.
